# EUROPÄISCHE PATENTANMELDUNG

(11) **EP 1 858 056 A1**
(43) Veröffentlichungstag der Anmeldung: **21.11.2007**
(21) Anmeldenummer: 07108039.4
(22) Anmeldetag: 11.05.2007
(51) Int. Cl.: H01J 37/32, C23C 14/00, C23C 16/455

(54) **Plasmaverfahren zur Oberflächenbehandlung von Werkstücken**

(30) Priorität: 17.05.2006 DE 102006023018
(71) Anmelder: Strämke, Siegfried, Dr., 52499 Baesweiler (DE); Strämke, Marc, 52499 Baesweiler (DE)
(72) Erfinder: Strämke, Siegfried, Dr., 52499 Baesweiler (DE); Strämke, Marc, 52499 Baesweiler (DE)
(74) Vertreter: von Kreisler Selting Werner

(57) **Zusammenfassung**

In einem druckdichten Reaktor (10) wird ein Teilvakuum erzeugt, in welchem ein Werkstück (13) eine Plasmabehandlung unterzogen wird. Der Druck im Raum (14) des Reaktors (10) wird periodisch oder aperiodisch verändert. Dadurch wird eine höhere Homogenität der Oberflächenschicht auf dem Werkstück (13) erreicht.

## Beschreibung

Die Erfindung betrifft ein Plasmaverfahren zur Oberflächenbehandlung von Werkstücken, bei weichem in einem Reaktor unter Teilvakuumbedingungen eine Plasmaentladung zwischen einer Elektrode und dem Werkstück durchgeführt wird.

Es ist bekannt, eine Oberflächenbehandlung von Werkstücken im Plasma durch Diffusion und/oder Beschichten durchzuführen. Hierunter fallen beispielsweise das Plasmanitrieren, Plasmaaufkohlen, Plasmaborieren, Plasmaoxidieren und das Beschichten mit Stoffen zur Verbesserung von Oberflächeneigenschaften wie Benetzung, Wärmeleitung, Korrosion, Verschleiß, Reibverhalten usw.. Die Oberflächenbehandlung kann durch PVD (Physical Vapour Deposition), PACVD (Plasma Activated Chemical Vapor Deposition) oder ähnliche Behandlungen erfolgen. Bei allen diesen Prozessen wird durch eine elektrische Entladung mit Gleichstrom, Wechselstrom oder Hochfrequenz ein Plasma zwischen dem Werkstück und einer Elektrode erzeugt. Im Patent DE 33 22 341 C2 des Anmelders ist ein Plasmaerzeugungsverfahren mit gepulster Plasmaentladung beschrieben, bei dem die elektrische Energie impulsweise zugeführt wird und die Entladeimpulse bestimmte Impulsformen haben.

Allen Plasmaprozessen ist gemeinsam, dass der Prozess konstant oder in Schritten bei dem jeweils als optimal empfundenen Prozessdruck abläuft. Diese Betriebsweise führt in gewissen Fällen zu einer ungleichmäßigen Behandlung der Werkstückoberfläche. Beispielsweise in Hohlkehlen oder hinter Graten und Spitzen entstehen Unregelmäßigkeiten oder Schatten der Plasmadichte, so dass eine homogene Oberflächenbehandlung nicht gewährleistet ist.

Der vorliegenden Erfindung liegt die Aufgabe zugrunde, ein Plasmaverfahren anzugeben, das eine gleichmäßigere Oberflächenbehandlung bietet.

Das erfindungsgemäße Verfahren weist die Merkmale des Patentanspruchs 1 auf. Erfindungsgemäß wird während der Plasma-Oberflächenbehandlung der Druck im Reaktor oder der Partialdruck eines Gases mindestens einmal erhöht und anschließend wieder verringert. Nach der Erfindung wird ein erhöhter Massentransport an die Fläche des Werkstücks durchgeführt. Eine Anzahl anderer von der Teilchendichte abhängiger Plasmaeffekte wird durch periodisches oder aperiodisches Pulsen des Drucks oder des Partialdrucks eines Gases in weiten Bereichen ausgenutzt. Versuche haben ergeben, dass ein pulsierender Druck zu einer besseren Verteilung der Plasmadichte über die Werkstückoberfläche beiträgt. Durch die Druckänderungen werden die Entladungen erschwert. Diese Erschwernis wird zugunsten einer Vergleichmäßigung der Oberflächenbehandlung auch bei unregelmäßigen Oberflächen in Kauf genommen. Zur Änderung der Teilchendichte oder des Druckes können unterschiedliche Verfahren angewendet werden. Im einfachsten Fall erfolgt ein schnelles Abpumpen von Gas aus dem Reaktor, beispielsweise durch Aktivierung eines Vakuumreservoirs und anschließende Druckerhöhung durch einen Druckstoß aus einem Vorratsbehälter. Zur Druckänderung können auch Stoßwellen, die z.B. mechanisch oder durch eine Gasentladung erzeugt werden können, benutzt werden. Es ist auch möglich, eine verdampfende Flüssigkeit in den Reaktor plötzlich einzuspritzen. In diesem Fall findet ein kurzzeitiger verstärkter Massentransport in den Reaktor statt.

Die anderen Plasmaparameter, wie Spannung und Strom, können synchron oder asynchron zu Teilchendichte oder Druck geändert werden.

Die Druckänderungen können abrupt oder in zeitlich gestreckter Form erfolgen. Bevorzugt sind Druckänderungen, die in kürzester Zeit erfolgen. Eine Druckänderung kann durch Einströmen von Gas oder durch eine Stoßwelle in sehr kurzer Zeit durchgeführt werden. Um dann den Reaktor wieder leer zu pumpen, wird in der Regel eine größere Zeitspanne benötigt. Daher sind die Druckimpulse in der Regel nicht symmetrisch. Vielmehr haben sie häufig eine steile Vorderflanke und eine relativ flache Rückflanke.

Die Druckparameter Druckverlauf, Frequenz, Maximum, Minimum usw. können auch von Impuls zu Impuls variieren. Diese Änderungen werden als Jitter bezeichnet.

Bei der Plasmabehandlung kann mindestens ein Parameter der Behandlung gemessen und in Abhängigkeit hiervon der Reaktionsfortschritt bestimmt und die Variation des Druckes geregelt oder gesteuert werden. Eine andere Alternative besteht darin, die Drucksteuerung rein zeitabhängig vorzunehmen und eine Zeitsteuerung durchzuführen.

Es besteht auch die Möglichkeit, die Menge bzw. den Volumenstrom eines Reaktanden, der dem Reaktor zugeführt wird, im Verlauf der Reaktion geregelt oder gesteuert zu variieren. Ferner können mehrere Reaktanden in zyklischer Folge dem Reaktor zugeführt werden.

Im Folgenden werden unter Bezugnahme auf die Zeichnungen Ausführungsbeispiele der Erfindung näher erläutert. Diese Erläuterungen sind nicht so zu verstehen, dass sie den Schutzbereich der Erfindung beschränken. Dieser wird vielmehr durch die Patentansprüche und deren Äquivalente bestimmt.

Es zeigen:
- Fig. 1: einen schematischen Querschnitt durch einen Reaktor mit darin befindlichem Werkstück während der Plasmaentladung.
- Fig. 2: eine andere Ausführungsform des Reaktors mit Hilfselektrode.
- Fig. 3: einen Längsschnitt durch einen Reaktor, dem mehrere Reaktionsgase zugeführt werden für die CVD Behandlung.
- Fig. 4: ein Diagramm eines zeitlichen Verlaufs des Druckes in dem Reaktor
- Fig. 5: ein Beispiel einer Anlage zur abrupten Erhöhung und Erniedrigung des Druckes in einem Reaktor.
- Fig. 6: ein Beispiel zur Druckerhöhung durch Einspritzen einer Flüssigkeit, vorzugsweise zum Oxidieren der Werkstückoberfläche.

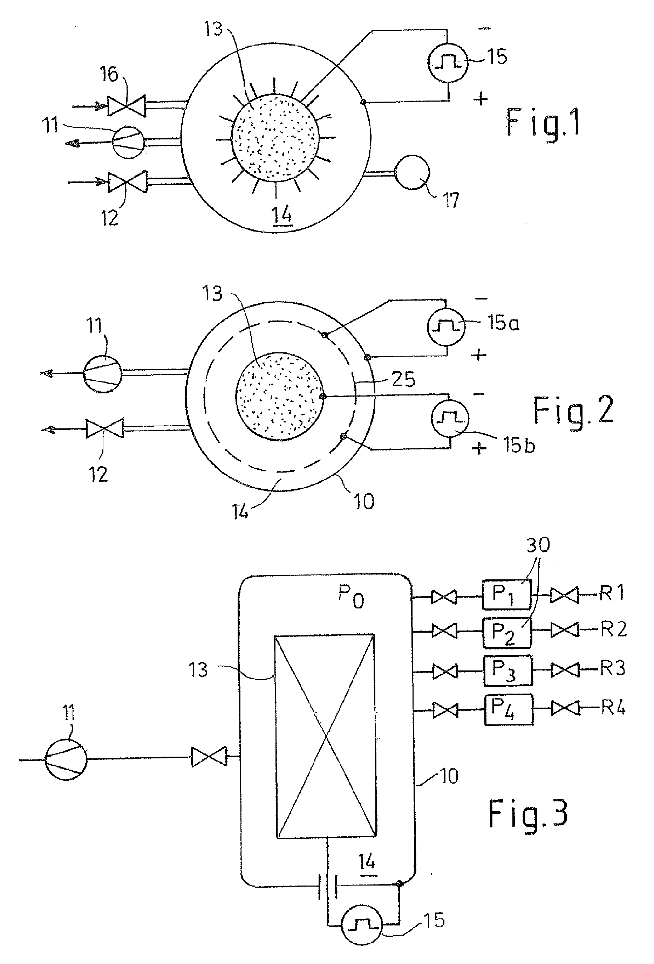

In Fig. 1 ist ein druckdichter Reaktor 10 dargestellt, in dem durch eine Vakuumpumpe 11 ein Vakuum erzeugt werden kann. In den Reaktor 10 kann durch ein Ventil 12 ein Prozessgas eingeleitet werden, um eine für das zu erzeugende Plasma geeignete Atmosphäre zu schaffen und mit dem Plasma einen Massentransport zum Werkstück zu bewirken.

Der Reaktor 10 enthält ein Werkstück 13, das im Reaktorraum 14 isoliert oder auf einem definierten Potential angeordnet ist und einen Abstand von der Reaktorwand einhält. Das Werkstück 13 besteht aus leitfähigem Material, insbesondere Metall. Auch die Wand des Reaktors 10 besteht aus Metall. Die Wand des Reaktors 10 und das Werkstück 13 sind an eine Spannungsquelle 15 angeschlossen. Der Pluspol der Spannungsquelle 15 ist mit der Wand des Reaktors 10 verbunden, die die Gegenelektrode für das Werkstück bildet. Der Minuspol der Spannungsquelle ist mit dem Werkstück verbunden. Die Spannungsquelle 15 ist z.B. eine gepulste Spannungsquelle, wie in DE 33 22 341 C2 beschrieben. Infolge der Glimmentladungen zwischen Reaktorwand und Werkstück entsteht in dem Raum 14 ein Plasma, wodurch ein Materialtransport von Spezies des Plasmagases zum Werkstück stattfindet. Das gleiche System kann bei nicht leitendem Werkstück auch mit Hochfrequenzerzeugung betrieben werden.

Das Ventil 12, durch welches das Prozessgas in den Reaktor 10 eingelassen wird, wird während der Behandlung vorübergehend geöffnet, so dass mehr Prozessgas in den Reaktor einströmen kann und der Druck im Raum 14 erhöht wird. Durch Absaugen mit der Vakuumpumpe 11 wird anschließend der Behälterdruck wieder verringert. Dadurch entsteht in dem Raum 14 ein variierender oder pulsierender Druck. Die Druckänderungen können periodisch erfolgen oder nach einem beliebigen anderen Muster. Vorzugsweise schließt sich an jeden Puls, d. h. jede vorübergehende Druckerhöhung, eine längere Impulslücke an, bei der stationär mit geringem Druck gearbeitet wird. Während der Plasmabehandlung können andere Plasmaparameter, wie Spannung oder Strom, synchron oder asynchron zu dem Druck verändert werden.

Ein Drucksensor 17 misst den Druck im Raum 14 und steuert oder regelt in Abhängigkeit hiervon Verfahrensparameter.

Das Werkstück 13 kann aus einem einzigen Körper bestehen oder auch aus einer Ansammlung verschiedener Teile, die beispielsweise in einem Korb enthalten sind.

Mit der in Fig. 1 dargestellten Apparatur kann als relativ einfacher Prozess unter anderem das "Oxidieren im Plasma" durchgeführt werden. Zu Beginn wird das Werkstück 13 in dem Reaktor 10 positioniert und dieser dicht verschlossen. Dann wird die Luft aus dem Raum 14 abgepumpt, bis ein Druck von z.B. 50 P erreicht ist. Wird das Plasma gezündet, das zwischen Werkstück und Gegenelektrode entsteht, wird die Werkstückoberfläche aktiviert. Anschließend wird durch das Ventil 16 Wasser kurzzeitig in den Raum 14 eingespritzt, wobei sich der Druck durch das verdampfende Wasser und durch die einsetzende Reaktion auf beispielsweise 50.000 P erhöht. P (=Pascal) ist die Einheit des Druckes. 1 P entspricht 1 N/m². 100 P entsprechen 1 mbar, oder 10⁵ P = 1 bar. Das Plasma erlischt dabei. Nach einer definierten Reaktionszeit wird das Reaktionsprodukt in Stufen oder kontinuierlich aus dem Raum 14 abgepumpt und das Plasma wieder gezündet, wobei die Stufen entsprechend den Erfordernissen der Entladung gewählt werden. Durch Messung des Anstiegs der Reaktionsprodukte kann der Reaktionsverlauf bestimmt und über geeignete Mittel die Reaktion gesteuert oder geregelt werden. Als Ergebnis erhält man eine dichte, hervorragend haftende Oxidschicht auf dem Werkstück.

Alternativ kann der Druck auch linear oder in Stufen erhöht werden. Hierbei wird das Wasser nicht abrupt sondern über einen längeren Zeitraum eingesprüht.

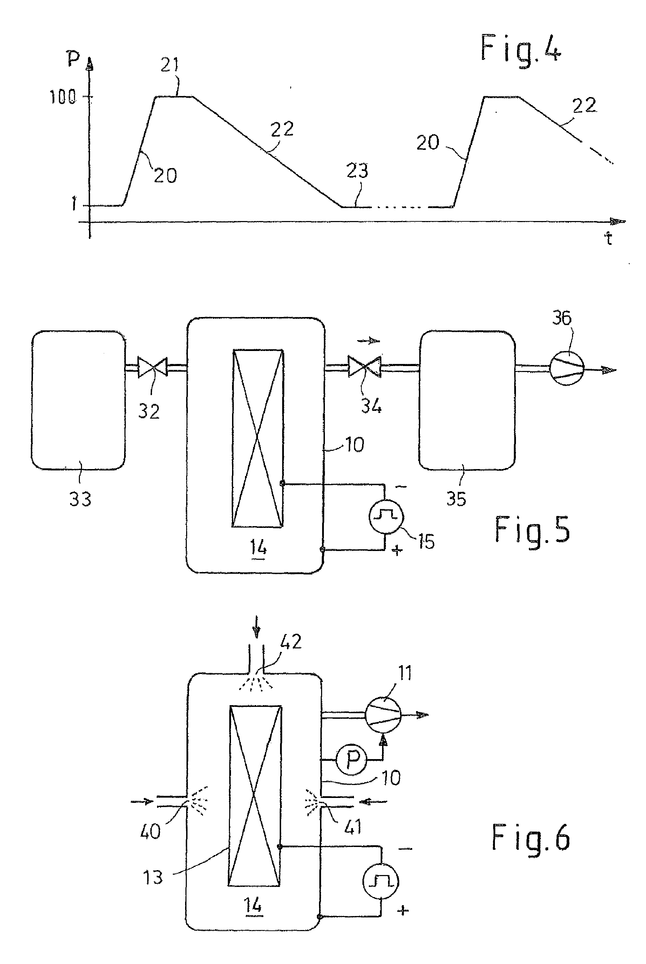

Ein anderes Verfahren, bei dem die erfindungsgemäßen Druckvariationen durchgeführt werden können, ist das Plasmanitrieren. Hierbei wird in dem Raum 14 nach Abpumpen der Luft eine Stickstoffatmosphäre durch das Ventil 12 erzeugt. Der Druck der Stickstoffatmosphäre wird periodisch oder aperiodisch verändert. Ein Beispiel für den zeitlichen Verlauf des Druckes P ist in Fig. 4 dargestellt. In diesem Beispiel sind relativ steile Druckanstiege 20 vorgesehen, die jeweils gefolgt sind von einem kurzen Abschnitt 21 konstanten und hohen Drucks. Daran schließen sich jeweils ein abfallender Abschnitt 22 an, in dem die Vakuumpumpe 11 das Gas aus dem Raum 14 abpumpt, bis der untere Druck 23 wieder erreicht ist. Die elektrische Leistung wird während des Behandlungsverlaufs erhöht. Als Ergebnis erhält man eine sehr gute Plasmanitrierung der Werkstückoberfläche, bei der die sonst unausweichliche Bevorzugung und Schattierung von Kanten und Hohlkehlen unterbleibt.

In Fig. 2 ist ein Reaktor 10 dargestellt, der generell ähnlich ausgebildet ist wie bei dem Ausführungsbeispiel von Fig. 1, jedoch in dem Raum 14 eine Hohlelektrode 25 in Form eines Gitterkorbes aufweist, welche das Werkstück 13 mit Abstand umgibt und zwischen Werkstück und Reaktorwand angeordnet ist. Eine erste Spannungsquelle 15a legt eine Spannung zwischen Reaktorwand und Gitter 25. Eine zweite Spannungsquelle 15b legt eine Spannung zwischen Werkstück 13 und Gitter 25. Die Änderung des Druckes wird hier nicht durch Zuschießen und Absaugen bewirkt, sondern durch eine Druckwelle, die durch Entladung zwischen dem Gitter 25 und der umhüllenden Reaktorwand 10 erzeugt wird. Ein ähnlicher Effekt kann auch durch periodische oder nicht periodische Modulation der Entladespannung erreicht werden. Dabei kann die Amplitude, das Tastverhältnis, die Pulsdauer oder die Pulspause moduliert werden. Eine derartige Druckwellenerzeugung ist auch ohne Verwendung des Gitters 25, das auf einem speziellen Potential liegt, möglich, beispielsweise mit der in Fig. 1 dargestellten Vorrichtung, bei der die Spannungsquelle 15 in geeigneter Weise moduliert wird. Desgleichen ist es auch möglich, das Gitter in einzelne Segmente zu unterteilen und diese sequentiell an eine oder mehrere Spannungsquellen zu legen. Die hier als Gitter bezeichnete Struktur kann ebenso eine komplexere Hohlkathodenstruktur sein, z.B. eine Honigwabenstruktur besitzen.

Fig. 3 zeigt ein Ausführungsbeispiel zur Durchführung eines CVD-Prozesses. Hierbei wird beispielsweise TiN auf Stahl oder einem anderen Material, wie Titan, Hartmetall, Nickelbasislegierung usw. abgeschieden. Bei den bekannten Verfahren lässt es sich nicht vermeiden, dass eine bestimmte Menge HCl, z.B. 0,5%, in die Schicht miteingebaut wird. Dadurch werden die Schichthaftung und das Korrosionsverhalten negativ beeinflusst,

In Fig. 3 ist eine Vorrichtung zur Durchführung des CVD-Prozesses dargestellt. Der Reaktor enthält mehrere Einlässe für verschiedene Reaktanden R1, R2, R3, R4. Jeder Reaktand wird über einen Druckregler 30, der einen bestimmten Partialdruck P1, P2, P3, P4 vorgibt, in den Reaktor 10 eingeführt. In dem Raum 14 des Reaktors 10 ergibt sich der Druck P_{O}.

Die Vorrichtung nach Fig. 3 ermöglicht es, nicht nur den Druck im Raum 14 gezielt zu verändern, sondern auch den Partialdruck der einzelnen Reaktanden. Man erreicht dadurch ein Reinigen der in dünner Lage aufgebrachten Oberflächenschicht und reduziert bei dem erwähnten CVD-Prozess den Chloranteil substantiell. Haftung und Korrosionseigenschaften werden wesentlich verbessert. Außerdem sind große Chargen gleichmäßig behandelbar.

Ein weiteres Beispiel betrifft die Erzeugung einer Multilayerschicht aus Titan, Bor, Aluminium und weiteren Elementen. Die Multilayerschicht wird erzeugt durch abwechselndes Einbringen der Metalle synchron oder asynchron zum Prozessverlauf mit der Vorrichtung nach Fig. 3.

In Fig. 5 ist eine Vorrichtung dargestellt, bei der der Reaktor 10 über ein steuerbares erstes Ventil 32 mit einem Gasbehälter 33 verbunden ist. Außerdem ist der Reaktor 10 über ein steuerbares zweites Ventil 34 mit einem Vakuumbehälter 35 verbunden, in dem durch eine Vakuumpumpe 36 ein Teilvakuum erzeugt wird. Durch abwechselndes Öffnen der Ventile 32 und 34 kann der Druck im Raum 14 in der beschriebenen Weise abrupt verändert werden.

Fig. 6 zeigt das Beispiel des Plasmaoxidierens durch in den Raum 14 eingesprühtes Wasser. Auch hier erzeugt eine Vakuumpumpe 11 in dem Raum 14 ein Teilvakuum. In dieses wird plötzlich Wasser durch Düsen 40, 41, 42 eingesprüht, wodurch eine Druckerhöhung erfolgt und eine Oxidation der Werkstückoberfläche erreicht wird. Anschließend werden die Düsen 40, 41, 42 wieder gesperrt, so dass die Vakuumpumpe 11 den Druck im Raum 14 wieder absenkt.

## Patentansprüche

1. Plasmaverfahren zur Oberflächenbehandlung von Werkstücken (13), bei welchem in einem Reaktor (10) unter Teilvakuumbedingungen eine Plasmaentladung zwischen einer Elektrode und dem Werkstück (13) durchgeführt wird,
**dadurch gekennzeichnet,**
**dass** während der Behandlung der Druck im Reaktor (10) oder der Partialdruck (P1-P4) eines Gases mindestens einmal erhöht und anschließend wieder verringert wird.

2. Plasmaverfahren nach Anspruch 1, **dadurch gekennzeichnet, dass** der Druck schlagartig erhöht oder verringert wird.

3. Plasmaverfahren nach Anspruch 1 oder 2, **dadurch gekennzeichnet, dass** der Druck nach einer vorgegebenen Funktion erhöht oder verringert wird.

4. Plasmaverfahren nach einem der Ansprüche 1 - 3, **dadurch gekennzeichnet, dass** die Druckänderungen periodisch durchgeführt werden.

5. Plasmaverfahren nach einem der Ansprüche 1 - 4, **dadurch gekennzeichnet, dass** der erhöhte Druck für eine Zeitdauer aufrecht erhalten wird, bevor durch Abpumpen eine Drucksenkung erfolgt.

6. Plasmaverfahren nach einem der Ansprüche 1 - 5, bei dem ein niedriger Druck für eine Zeitdauer gehalten wird, bevor die Druckerhöhung erfolgt.

7. Plasmaverfahren nach einem der Ansprüche 1 - 5, **dadurch gekennzeichnet, dass** der Druck im Bereich von 1-2000 P variiert wird.

8. Plasmaverfahren nach einem der Ansprüche 1 - 6, **dadurch gekennzeichnet, dass** der Partialdruck (P1-P4) eines in den Reaktor (10) eingeführten Reaktanden (R1-R4) verändert wird.

9. Plasmaverfahren nach einem der Ansprüche 1 - 7, **dadurch gekennzeichnet, dass** der Druck über ein Vielfaches einer Periode hinweg periodisch oder aperiodisch verändert wird (Jitter).

10. Plasmaverfahren nach Anspruch 9, **dadurch gekennzeichnet, dass** der Jitter einer vorgegebenen Verteilungsfunktion folgt, z.B. symmetrische Drucksprünge bezogen auf einen Mittelwert bzw. symmetrische Leistungsverteilung des Plasmas auf Grund der Drucksprünge.

11. Plasmaverfahren nach einem der Ansprüche 1 - 10, **dadurch gekennzeichnet, dass** mindestens ein Parameter der Behandlung gemessen und in Abhängigkeit hiervon der Reaktionsfortschritt bestimmt und die Variation des Druckes geregelt oder gesteuert wird.

12. Plasmaverfahren nach einem der Ansprüche 1 - 11, **dadurch gekennzeichnet, dass** in Abhängigkeit von der Größe mindestens eines Parameters eine vorübergehende Druckänderung im Reaktor durchgeführt wird.

13. Plasmaverfahren nach einem der Ansprüche 1 - 12, **dadurch gekennzeichnet, dass** bei einem Oxidationsverfahren als Oxidationsmittel Wasser verwendet wird und die Menge des zugeführten Wassers aus dem durch die Reaktion hervorgerufenen Druckanstieges bestimmt wird.

14. Plasmaverfahren nach einem der Ansprüche 1 - 13, **dadurch gekennzeichnet, dass** das Plasma zwangsweise vorübergehend unterbrochen wird.

15. Plasmaverfahren nach einem der Ansprüche 1 - 14, **dadurch gekennzeichnet, dass** die Menge mindestens eines, dem Reaktor (10) zugeführten, Reaktanden im Verlauf der Reaktion geregelt oder gesteuert variiert wird.

16. Plasmaverfahren nach einem der Ansprüche 1 - 15, **dadurch gekennzeichnet, dass** mehrere Reaktanden (R1-R4) in zyklischer Folge dem Reaktor (10) zugeführt werden.

17. Plasmaverfahren nach einem der Ansprüche 1 - 16, **dadurch gekennzeichnet, dass** eine Plasmavariation durch Zünden einer oder mehrerer Hohlelektroden (25) erfolgt.

18. Plasmaverfahren nach einem der Ansprüche 1 - 17, **dadurch gekennzeichnet, dass** eine Plasmavariation durch Zünden einer oder mehrerer Zusatzelektroden erfolgt.

19. Plasmaverfahren nach einem der Ansprüche 1 - 18, **dadurch gekennzeichnet, dass** eine Plasmavariation durch gezieltes Ein- bzw. Umschalten mehrerer Elektroden erfolgt.
